# EUROPEAN PATENT APPLICATION

(11) **EP 0 863 436 A1**
(43) Date of publication of application: **09.09.1998**
(21) Application number: 98103712.0
(22) Date of filing: 03.03.1998
(51) Int. Cl.: G03F 7/075, G03F 7/004

(54) **Heat resistant photosensitive polymer composition, process for forming pattern and semiconductor device**

(30) Priority: 03.03.1997 JP 47457/97; 28.05.1997 JP 138347/97; 11.09.1997 JP 246813/97
(71) Applicant: HITACHI CHEMICAL CO., LTD., Shinjuku-ku, Tokyo (JP)
(72) Inventor: Nunomura, Masataka, Hitachi-shi, Ibaraki-ken (JP); Sasaki, Mamoru, Hitachi-shi, Ibaraki-ken (JP); Uchimura, Shunichiro, Hitachi-shi, Ibaraki-ken (JP); Ohe, Masayuki, Hitachi-shi, Ibaraki-ken (JP); Nishio, Shigeru, Yokohama-shi, Kanagawa-ken (JP)
(74) Representative: Hansen, Bernd, Dr. Dipl.-Chem.

(57) **Abstract**

The present invention provides a heat resistant photosensitive polymer composition of positive tone capable of forming a heat resistant polyimide usable as a buffer coating for an electronic component or as an interlayer dielectric film by heat treatment; process for forming a pattern with the composition; and a semiconductor device. This composition comprises (a) a polyimide precursor or a polyimide having a carboxyl group or a phenolic hydroxyl group, (b) a polyamic acid having a siloxane bond, and (c) a photo acid generator.

## Description

### Background of the Invention

The present invention relates to a heat resistant photosensitive polymer composition, a process for forming a pattern with this composition and a semiconductor device. In particular, the present invention relates to a heat resistant photosensitive polymer composition of positive tone capable of forming a heat resistant polyimide usable as a buffer coating for an electronic component such as a semiconductor device or as an interlayer dielectric film by heat treatment; a process for forming a pattern with the composition; and a semiconductor device.

Polyimides are widely used as buffer coatings for semiconductor devices and also as interlayer dielectric films, taking advantage of excellent heat resistance and mechanical properties thereof, and of easiness of forming films thereof and also capability of forming the flat surfaces.

When a polyimide is used for forming a buffer coating or interlayer dielectric film, through-holes are formed mainly by an etching process wherein a positive photoresist is used. However, this process has a problem that the application and peeling of the photoresist are included in the step of forming the through-holes to make the step complicated. Under these circumstances, investigations were made for the purpose of developing a photosensitive, heat resistant materials so as to rationalize the operation steps.

Photosensitive polyimide compositions known in the art include a polyimide precursor composition having a photosensitive group introduced by an ester bond [see, for example, Japanese Patent Publication for Opposition Purpose (hereinafter referred to as "J. P. KOKOKU") No. Sho 55-30207] and a composition obtained by adding a compound containing a carbon-to-carbon double bond dimerizable or polymerizable by chemical rays, an amino group and an aromatic bisazide to a polyamic acid (see, for example, J. P. KOKOKU No. Hei 3-36861).

The photosensitive polyimide composition is used usually as follows: this composition in the form of a solution thereof is applied to a support, dried and then irradiated with an active radiation through a mask, and the exposed area is removed with a developer to form a pattern.

However, the above-described composition is of negative tone, and an organic solvent is used for the development. Therefore, when the negative photosensitive polyimide is used in place of the positive photoresist used in the etching process, the mask of the exposing equipment and the developing processor must be changed unfavorably.

Known positive tone photosensitive polyimides include a polyimide precursor containing an o-nitrobenzyl group introduced into the ester bond [Japanese Patent Unexamined Published Application (hereinafter referred to as "J. P. KOKAI") No. Sho 60-37550] and a composition comprising a carboxyl group-containing polyamic acid ester and an o-quinonediazide compound [J.P.Kokai No.Hei4-168441, USP-5104768]. However, the former has a problem that the sensitivity thereof is low because it is sensitive to a light having a wave length of mainly not longer than 300 nm, and also the latter has a problem that the adhesion of the formed film to the support is insufficient. Thus, positive photosensitive polyimide having satisfactory properties cannot be obtained at present.

### Summary of the Invention:

The object of the present invention is to overcome the above-described problems of the prior art.

Namely, the object of the present invention is to provide a heat resistant photosensitive polymer composition of positive tone, which has a high sensitivity, which necessitates only a short development time and which is capable of forming a film having excellent properties, particularly a high adhesion to the support.

Another object of the present invention is to provide a process for producing a pattern which has a high sensitivity, which necessitates only a short development time and which is capable of forming a membrane having excellent properties, particularly a high adhesion to the support.

Still another object of the present invention is to provide a highly reliable semiconductor equipment wherein the buffer coating or interlayer dielectric film has a high adhesion to the support. The present invention relates to a heat resistant photosensitive polymer composition comprising:
(a) a polyimide precursor or a polyimide having a carboxyl group or a phenolic hydroxyl group,
(b) a polyamic acid having a siloxane bond, and
(c) a photo acid generator.

The present invention relates also to the heat resistant photosensitive polymer composition wherein the polyimide precursor or a polyimide (a) having a carboxyl group or a phenolic hydroxyl group is selected from among the following compounds having the following repeating unit:
polyamic acid esters having a repeating unit of the general formula (1): 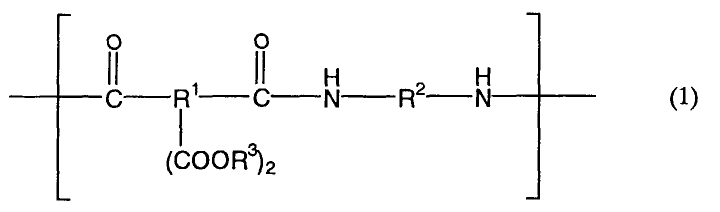 wherein R ¹ represents a tetravalent organic group, R² represents a divalent organic group having a carboxyl group or a phenolic hydroxyl group, and R³ represents a monovalent organic group,
polyamic acid amides having a repeating unit of the general formula (2): 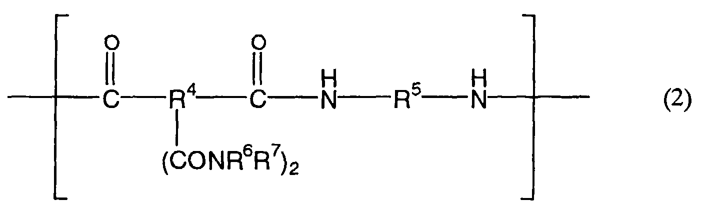 wherein R⁴ represents a tetravalent organic group, R⁵ represents a divalent organic group having a carboxyl group or a phenolic hydroxyl group, and R⁶ and R⁷ each represent a hydrogen atom or a monovalent organic group, and polyimides having a repeating unit of the general formula (3): 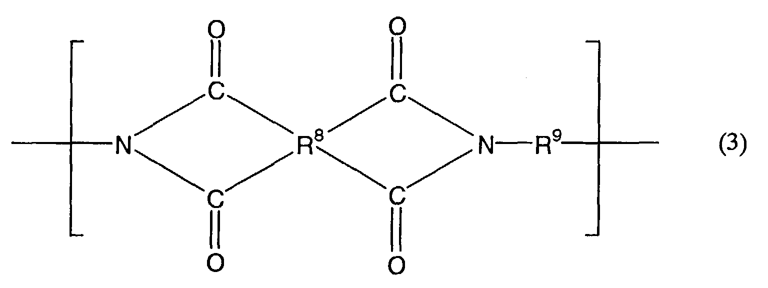 wherein R⁸ represents a tetravalent organic group and R⁹ represents a divalent organic group having a phenolic hydroxyl group.

The present invention relates also to the heat resistant photosensitive polymer composition wherein the polyamic acid (b) having a siloxane structure is a polyamic acid having a repeating unit of the general formula (4): 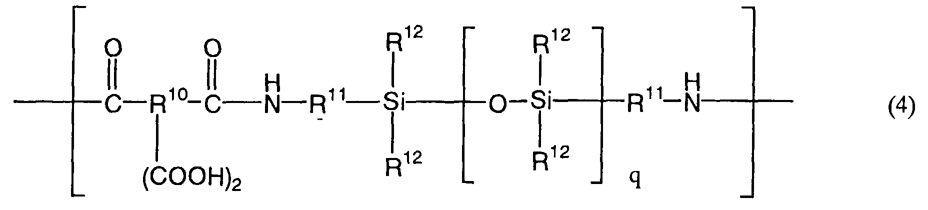 wherein R ¹⁰ represents a tetravalent organic group, R¹¹ represents a divalent organic group, R¹² represents a monovalent organic group, and q represents an integer of at least 1.

The present invention relates also to the heat resistant photosensitive polymer composition wherein the photo acid generator (c) is an o-quinone diazide compound.

The present invention relates also to a process for producing a pattern, which comprises a step of applying the heat resistant photosensitive polymer composition to a support and drying it, followed by an exposing step, a developing step and a heat treatment step.

Further, the present invention relates to a semiconductor device having a polyimide resin film comprising the heat resistant photosensitive polymer composition.

### Description of the Preferred Embodiments

For obtaining high sensitivity, excellent pattern-forming property, high solubility of the exposed area in an aqueous alkali solution and excellent membrane properties such as heat resistance, the component (a) in the present invention must be a polyimide precursor or polyimide having a carboxyl group or phenolic hydroxyl group.

The term "polyimide precursor" herein indicates the one which can be converted into a polyimide by the heat treatment. The polyimide precursors having a carboxyl group or a phenolic hydroxyl group include polyamic acids, polyamic acid esters and polyamic acid amides having such a group.

For obtaining a high sensitivity, excellent pattern-forming property and high solubility of the exposed area in an aqueous alkali solution, the component (a) in the present invention is preferably a polyamic acid ester having a repeating unit of the above general formula (1), a polyamidic acid amide having a repeating unit of the above general formula (2) or a polyimide having a repeating unit of the above general formula (3). Among them, the polyamic acid esters having the repeating unit of the above general formula (1) are preferred.

The tetravalent organic groups represented by R¹ in the above general formula (1) are residues derived from tetracarboxylic acids reactive with a diamine to form a polyimide structure or from derivatives of these acids such as dianhydrides thereof. These groups include tetravalent aromatic groups and aliphatic groups. Those having 4 to 40 carbon atoms are preferred. Tetravalent aromatic groups having 4 to 40 carbon atoms are more preferred. The tetravalent aromatic groups are preferably those having an aromatic ring (such as benzene ring or naphthalene ring), wherein the four positions of bonding them are on the aromatic ring. It is also preferred that the four bonding positions are divided into two groups each consisting of two bonding positions and that the two bonding positions are on carbon atoms, adjacent to each other, of an aromatic ring (namely, they are in the o-positions or peri-positions with each other). The two couples of the bonding positions may be on the same aromatic ring or on different aromatic rings bonded to each other through one of various bonds.

The divalent organic groups R² having a carboxyl group or a phenolic hydroxyl group in the general formula (1) are diamine compound residues obtained from the diamine compounds having a carboxyl group or a phenolic hydroxyl group by removing an amino group therefrom, which residues are capable of reacting with a tetracarboxyic acid to form a polyimide structure. These groups R² include aromatic groups and aliphatic groups, preferably those having 2 to 40 carbon atoms excluding the carbon atoms of the carboxyl group. Aromatic groups having such a number of carbon atoms are more preferred. The term "aromatic groups" herein indicates those having an aromatic ring (such as a benzene ring or naphthalene ring) wherein the two bonding positions are preferably on the same or different aromatic rings. The number of the carboxyl group(s) or phenolic hydroxyl group(s) is preferably 1 to 8. These groups are preferably directly bonded to the aromatic ring.

The monovalent organic groups R³ in the general formula (1) include aliphatic groups and aromatic groups having preferably 1 to 20 carbon atoms. Aliphatic hydrocarbon groups and aromatic hydrocarbon groups having 1 to 20 carbon atoms are more preferred.

The component (a) may have a repeating unit other than that of the general formula (1). For example, the component (a) may have a repeating unit of the following general formula (5): 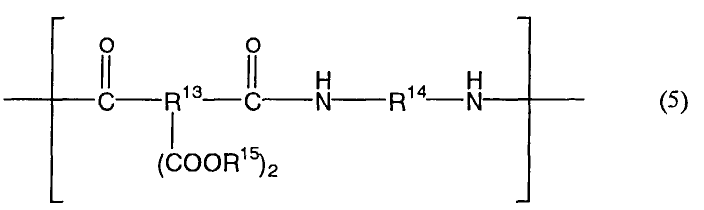 wherein R¹³ represents a tetravalent organic group, R¹⁴ represents a divalent organic group free of carboxyl group and phenolic hydroxyl group, and R¹⁵ represents a monovalent organic group.

The tetravalent organic groups represented by R¹³ in the general formula (5) include those described above with reference to R¹. The divalent organic groups R¹⁴ free of carboxyl group and phenolic hydroxyl group in the general formula (5) include those described above with reference to R² but free of carboxyl group and phenolic hydroxyl group. The monovalent organic groups represented by R¹⁵ in the general formula (5) are those described above with reference to R³.

The polyamic acid ester having the repeating unit of the general formula (1) may also have another repeating unit such as that of the general formula (1) or (5) wherein one or both of the two R³ 's or two R¹⁵'s are replaced with hydrogen atom.

In the polyamic acid ester comprising the repeating unit of the general formula (1), the ratio of the repeating unit of the general formula (1) to that of the general formula (5) is preferably as follows: m/(m+n) = 0.2 to 1, and more preferably m/(m+n) = 0.4 to 1 (wherein m represents the number of the repeating units of the former and n represents that of the latter). When m/(m+n) is below 0.2, the solubility of the polyamic acid ester in an aqueous alkali solution inclines to be low.

In the polyamic acid ester comprising the repeating unit of the general formula (1), the total number of the repeating units of the general formulae (1) and (5), namely the total number of the repeating units wherein the carboxyl groups in the tetracarboxylic acid residue are completely esterified, is preferably 50 to 100 %, more preferably 80 to 100 %, and particularly 90 to 100 %, based on the total number of the repeating units.

The term "repeating unit" herein indicates a unit composed of one acid residue and one amine residue.

The weight-average molecular weight of the polyamic acid ester having the repeating unit of the general formula (1) is preferably 3,000 to 200,000, more preferably 5,000 to 100,000. The molecular weight is determined according to gel permeation chromatograhy followed by the calculation from a standard polystyrene calibration curve.

In two or more repeating units of the polyamic acid ester, represented by the general formula (1), the groups R^{1,} R² and R³ may be the same or different from each other.

The polyamic acid esters having the repeating unit of the general formula (I) in the present invention can be obtained by, for example, reacting a tetracarboxylic acid diester dihalide (such as chloride or bromide) with a diamine compound having a carboxyl group or a phenolic hydroxyl group and, if necessary, a diamine compound free of carboxyl group and phenolic hydroxyl group.

This reaction is carried out preferably in the presence of a haloacid-removing catalyst in an organic solvent.

The tetracarboxylic acid diester dihalides are preferably tetracarboxylic acid diester dichlorides. The tetracarboxylic acid diester dichlorides can be obtained by reacting a tetracarboxylic acid diester, obtained by the reaction of a tetracarboxylic acid dianhydride with an alcohol compound, with thionyl chloride.

The tetracarboxylic acid dianhydrides are preferably aromatic tetracarboxylic acid dianhydrides such as pyromellitic dianhydride, 3,3',4,4'-biphenyltetracarboxylic dianhydride, 2,3,3',4'-biphenyltetracarboxylic dianhydride, 2,2',3,3'-biphenyltetracarboxylic dianhydride, 3,3',4,4'-bensophenonetetracarboxylic dianhydride, 3,3',4,4'-biphenyl ether tetracarboxylic dianhydride, 3,3',4,4'-diphenylsulfonetetracarboxylic dianhydride, 1,2,3,4-cyclopentanetetracarboxylic dianhydride, 1,2,5,6-naphthalenetetracarboxyic dianhydride, 2,3,6,7-naphthalenetetracarboxylic dianhydride, 1,4,5,8-naphthalenetetracarboxylic dianhydride, 2,3,5,6-pyridinetetracarboxylic dianhydride, 3,4,9,10-perylenetetracarboxylic dianhydride, 3,3',4,4'-diphenylsulfonetetracarboxylic dianhydride, 3,3',4,4'-tetrahenylsilanetetracarboxylic dianhydride and 2,2-bis(3,4-dicarboxyphenyl)hexafluoropropane dianhydride.
They are usable either alone or in combination of two or more of them.

The alcohol compounds are preferably alkyl alcohols such as methanol, ethanol, n-propyl alcohol, isopropyl alcohol, n-butyl alcohol, sec-butyl alcohol, tert-butyl alcohol, isobutyl alcohol, l-pentanol, 2-pentanol, 3-pentanol, isoamyl alcohol, l-hexanol, 2-hexanol and 3-hexanol; phenol; and bensyl alcohol. They are usable either alone or in combination of two or more of them.

The diamines having carboxyl group or phenolic hydroxyl group are preferably aromatic diamine compounds such as 2,5-diaminobenzoic acid, 3,4-diaminobenzoic acid, 3,5-diaminobenzoic acid, 2,5-diaminoterephthalic acid, bis(4-amino-3-carboxyphenyl) methylene, bis(4-amino-3-carboxyphenyl) ether, 4,4'-diamino-3,3'-dicarboxybiphenyl, 4,4'-diamino-5,5'-dicarboxy-2,2'-dimethylbiphenyl, 1,3-diamino-4-hydroxybenzene, 1,3-diamino-5-hydroxybenzene, 3,3'-diamino-4,4'-dihydroxybiphenyl, 4,4'-diamino-3,3'-dihydroxybiphenyl, bis(3-amino-4-hydroxyphenyl)propane, bis(4-amino-3-hydroxyphenyl)propane, bis(3-amino-4-hydroxyphenyl)sulfone, bis(4-amino-3-hydroxyphenyl)sulfone, bis(3-amino-4-hydroxyphenyl)hexafluoropropane and bis(4-amino-3-hydroxy-phenyl)hexafluoropropane. They are usable either alone or in combination of two or more of them.

The diamines free of carboxyl group and phenolic hydroxyl group are preferably aromatic diamine compounds such as 4,4'-diaminodiphenyl ether, 4,4'-diaminodiphenylmethane, 4,4'-diaminodiphenylsulfone, 4,4'-diaminodiphenyl sulfide, benzidine, m-phenylenediamine, p-phenylenediamine, 1,5-naphthalenediamine, 2,6-naphthalenediamine, bis(4-aminophenoxyphenyl)sulfone, bis(3-aminophenoxyphenyl)sulfone, bis(4-aminophenoxy)biphenyl, bis[4-(4-aminophenoxy)phenyl] ether and 1,4-bis(4-aminophenoxy)benzene. They are usable either alone or in combination of two or more of them.

Other diamines free of carboxyl group and phenolic hydroxyl group and usable for improving the heat resistance include diamine compounds having a sulfonamide group or carboxamide group such as 4,4'-diaminodiphenyl ether-3-sulfonamide, 3,4'-diaminodiphenyl ether-4-sulfonamide, 3,4'-diaminodiphenyl ether-3'-sulfonamide, 3,3'-diaminodiphenyl ether-4-sullfonamide, 4,4'-diaminodiphenyl ether-3-carboxamide, 3,4'-diaminodiphenyl ether-4-carboxamide, 3,4'-diaminodiphenyl ether-3'-carboxamide and 3,3'-diaminodiphenyl ether-4-carboxamide. They are usable either alone or in combination of two or more of them. When a combination of diamine compounds is used, the amount of these diamines free of carboxyl group and phenolic hydroxyl group is preferably not larger than 15 molar %, more preferably not larger than 10 molar %, based on the whole diamine compounds.

Processes for synthesizing the tetracarboxylic acid diester compounds are known. For example, they can be obtained by mixing the tetracarboxylic acid dianhydride with an excess amount of the alcohol compound, heating the obtained mixture to conduct the reaction and removing a superfluous amount of the alcohol compound. The molar ratio of the tetracarboxylic acid dianhydride to the alcohol compound is preferably in the range of 1/2 to 1/20, more preferably 1/2.5 to 1/10. The reaction temperature is preferably 30 to 130 °C, and the reaction time is preferably 3 to 24 hours.

Processes for synthesizing the tetracarboxylic acid diester dichlorides are well known. For example, they can be obtained by reacting a tetracarboxylic acid diester with an excess amount of thionyl chloride under heating and then removing a superfluous amount of thionyl chloride. The molar ratio of the tetracarboxylic acid diester to excess thionyl chloride is preferably in the range of 1/2 to 1/10, more preferably 1/2.2 to 1/5. The reaction temperature is preferably 0 to 100 °C, and the reaction time is preferably 1 to 10 hours.

The polyamic acid esters having the repeating unit of the general formula (1) are obtained by dissolving the diamine compound and a haloacid-removing catalyst such as pyridine in an organic solvent, dropping a solution of a tetracarboxylic acid diester dihalide in an organic solvent into the obtained solution to conduct the reaction, feeding the obtained reaction mixture into a poor solvent such as water to form precipitates, and filtering and drying the precipitates. The molar ratio of the whole diamine compounds to the tetracarboxylic acid diester dihalide is preferably in the range of 0.95/1 to 1/0.95, more preferably 0.98/1 to 1/0.98. The reaction temperature is preferably -30 to 40 °C, and the reaction time is preferably 1 to 10 hours. The molar ratio of the haloacid-removing catalyst to the tetracarboxylic acid diester dihalide is preferably in the range of 0.95/1 to 1/0.95, more preferably 0.98/1 to 1/0.98.

When the diamine compound free of carboxyl group and phenolic hydroxyl group is also used, the relative amounts of the diamine compound having carboxyl group or phenolic hydroxyl group and such a diamine compound are such that preferably 20 to 100 molar % of the former and 80 to 0 molar % of the latter are used, more preferably, 40 to 100 molar % of the former and 60 to 0 molar % of the latter are used, the total of them being 100 molar %. When the amount of the former diamine compound used for imparting a solubility in an aqueous alkali solution to the polyamic acid ester is below 20 molar %, the sensitivity is reduced and the development time is prolonged.

Now, the description will be made on the polyamic acid amides having the repeating unit represented by the above general formula (2).

The tetravalent organic groups represented by R⁴ in the above general formula (2) are the same as those described above with reference to R¹ in the general formula (1). The divalent organic groups R⁵ having carboxyl group or phenolic hydroxyl group in the above general formula (2) are the same as those described with reference to R² in the above general formula (1). The monovalent organic groups R⁶ and R⁷ in the above general formula (2) are the same as those described with reference to R³ in the above general formula (1).

The polyamic acid amides having the repeating unit of the general formula (2) may have a repeating unit different from it. For example, the repeating units different from those of the general formula (2) include those of the following general formula (6): 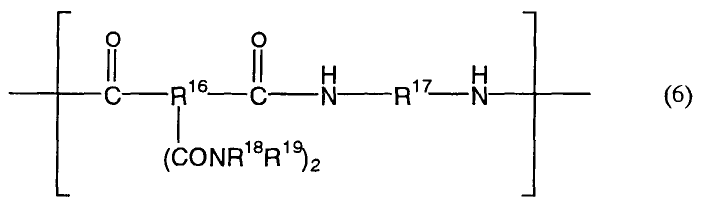 wherein R¹⁶ represents a tetravalent organic group, R¹⁷ represents a divalent organic group free of carboxyl group and phenolic hydroxyl group, and R¹⁸ and R¹⁹ each represent a hydrogen atom or a monovalent organic group.

The tetravalent organic groups represented by R¹⁶ in the above general formula (6) are the same as those described with reference to R¹ in the above general formula (1). The divalent organic groups R¹⁷ free of carboxyl group or phenolic hydroxyl group are the same as those free from carboxyl group and phenolic hydroxyl group described above with reference to R² in the general formula (1). The monovalent organic groups R¹⁸ and R¹⁹ in the above general formula (6) are the same as those described above with reference to R³ in the general formula (1).

The polyamic acid amides having the repeating unit of the general formula (2) may have a repeating unit different from it. For example, the repeating units different from those of the general formula (2) include those of the general formula (2) or (6) wherein either or both of the amido groups represented by the formulae: -CONR⁶R⁷ and -CONR¹⁸R¹⁹ are replaced with carboxyl group.

In the polyamic acid amides having the repeating units represented by the general formula (2), the ratio of the repeating unit (m) of the general formula (2) to the repeating unit (n) of the general formula (6) is such that m/(m+n) is preferably 0.2 to 1, more preferably 0.4 to 1. When m/(m+n) is below 0.2, the solubility in the aqueous alkali solution inclines to be low.

In the polyamic acid amide having the repeating unit of the general formula (2), the sum of the repeating units of the general formula (2) and general formula (6) or, in other words, the total number of the repeating units in which the carboxyl group in the polyamidic acid residue has been completely amidated, is preferably 50 to 100 %, more preferably 80 to 100 % and particularly preferably 90 to 100 %, based on the total repeating units.

The weight-average molecular weight of the polyamic acid amide having the repeating unit of the general formula (2) is preferably 3,000 to 200,000, more preferably 5,000 to 100,000. The molecular weight is determined according to gel permeation chromatograhy followed by the calculation from a standard polystyrene calibration curve.

In two or more repeating units of the polyamic acid amide represented by the general formula (2), the groups R⁴, R⁵, R⁶ and R⁷ may be the same or different from each other.

The polyamic acid amides having the repeating unit of the general formula (2) can be obtained by, for example, reacting a tetracarboxylic add diamide dihalide (such as chloride or bromide) with a diamine compound having carboxyl group or phenolic hydroxyl group and, if necessary, a diamine compound free of carboxyl group and phenolic hydroxyl group.

This reaction is carried out preferably in the presence of a haloacid-removing catalyst in an organic solvent.

The tetracarboxylic acid diamide dihalides are preferably tetracarboxylic acid diamide dichlorides. The tetracarboxylic acid diamide dichlorides can be obtained by reacting a tetracarboxylic acid diamide, obtained by the reaction of a tetracarboxylic acid dianhydride with an amine compound, with thionyl chloride.

The tetracarboxylic acid dianhydrides are those exemplified above as the starting materials for the polyamic acid esters having the repeating unit of the general formula (1).

The amine compounds are preferably primary amines such as methylamine, ethylamine, n-propylamine, isopropylamine, n-butylamine, sec-butylamine, tert-butylamine, isobutylamine, l-pentylamine, 2-pentylamine, 3-pentylamine, isoamylamine, 1-hexylamine, 2-hexylamine and 3-hexylamine; alicyclic amines such as dimethylamine, diethylamine, di-n-proylamine, diisopropylamine and di-n-butylamine; alicyclic amines such as piperidine, piperazine and morpholine; aniline; and benzylamine. They are usable either alone or in combination of two or more of them.

The diamines having carboxyl group or phenolic hydroxyl group include those illustrated above as the starting materials for the polyamic acid esters having the repeating unit of the above general formula (1). Also, the diamines free of carboxyl group and phenolic hydroxyl group include those illustrated above as the starting materials for the polyamic acid esters having the repeating unit of the general formula (1).

Processes for synthesizing the tetracarboxylic acid diamide compounds are well known. For example, these compounds are obtained by mixing the above-described tetracarboxylic acid dianhydride with an excess amount of the above-described amine compound, heating the obtained mixture to conduct the reaction and removing the superfluous amine compound. The molar ratio of the tetracarboxylic acid dianhydride to the amine compound is preferably in the range of 1/2 to 1/20, more preferably 1/2.5 to 1/10. The reaction temperature is preferably 30 to 130 °C, and the reaction time is preferably 3 to 24 hours.

Processes for synthesizing the tetracarboxylic acid diamide dichlorides are also well known. For example, these compounds are obtained by reacting a tetracarboxylic acid diamide with an excess amount of thionyl chloride under heating and then removing superfluous thionyl chloride. The molar ratio of the tetracarboxylic acid diamide to the excess thionyl chloride is preferably in the range of 1/2 to 1/10, more preferably 1/2.2 to 1/5. The reaction temperature is preferably 0 to 100 °C, and the reaction time is preferably 1 to 10 hours.

The polyamic acid amide is obtained by, for example, dissolving the diamine compound and the haloacid-removing catalyst such as pyridine in an organic solvent, dropping a solution of a tetracarboxylic acid diamide dihalide in an organic solvent to the obtained solution to conduct the reaction, throwing the reaction product into a poor solvent such as water, filtering a precipitate thus formed and drying the precipitate.The molar ratio of the whole diamine compounds to the tetracarboxylic acid diamide dihalide is preferably in the range of 0.95/1 to 1/0.95, more preferably 0.98/1 to 1/0.98. The reaction temperature is preferably -30 to 40°C, and the reaction time is preferably 1 to 10 hours. The molar ratio of the dehydrohalogenation agent to the tetracarboxylic acid diamide dihalide is preferably in the range of 0.95/1 to 1/0.95, more preferably 0.98/1 to 1/0.98.

When the diamine compound free of carboxyl group and phenolic hydroxyl group is also used in the production of the polyamic acid amide having the repeating unit of the general formula (2), the relative amounts of the diamine compound having carboxyl group or phenolic hydroxyl group and such a diamine compound are such that preferably 20 to 100 molar % of the former and 80 to 0 molar % of the latter are used, more preferably, 40 to 100 molar % of the former and 60 to 0 molar % of the latter are used; the total of them being 100 molar %. When the amount of the former diamine compound used for imparting a solubility in an aqueous alkali solution to the polyamic acid amide is below 20 molar %, the sensitivity is reduced and the development time is prolonged.

Now, the description will be made on the polyimides having the repeating unit represented by the above general formula (3).

The tetravalent organic groups represented by R⁸ in the general formula (3) include those described above with reference to R¹ in the general formula (1). The divalent organic groups R⁹ having the phenolic hydroxyl group in the general formula (3) include those having phenolic hydroxyl group described above with reference to R² in the general formula (1).

The polyimide of the general formula (3) may also have a constituting unit other than the repeating unit of the general formula (3). The constituting unit may be, for example, a repeating unit of the following general formula (7): 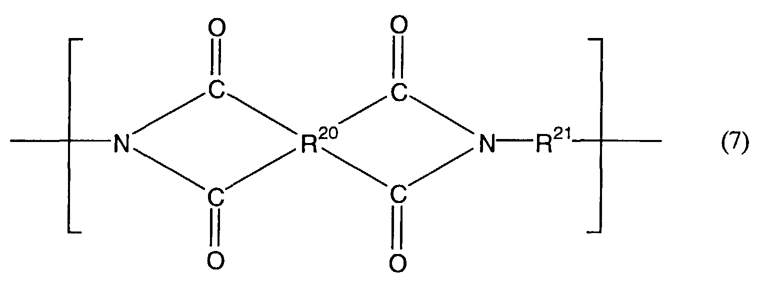 wherein R²⁰ represents a tetravalent organic group, R²¹ represents a divalent organic group free of phenolic hydroxyl group.

The tetravalent organic groups represented by R²⁰ in the general formula (7) are the same as those described above with reference to R¹. The divalent organic groups represented by R²¹ and free of phenolic hydroxyl group are those described above with reference to R² in the general formula (1) and free of phenolic hydroxyl group and also those described above with reference to R¹⁵ in the general formula (5).

In the polyimide having the repeating unit of the general formula (3), the ratio of the repeating unit of the general formula (3) to that of the general formula (7) is preferably as follows: m/(m+n) = 0.2 to l, and more preferably m/(m+n) = 0.4 to 1 (wherein m represents the number of the repeating units of the former and n represents that of the latter). When m/(m+n) is below 0.2, the solubility of the polyimide in an aqueous alkali solution inclines to be low.

The weight-average molecular weight of the polyimide having the repeating unit of the general formula (3) is preferably 3,000 to 200,000, more preferably 5,000 to 100,000. The molecular weight is determined according to gel permeation chromatograhy followed by the calculation from a standard polystyrene calibration curve.

In two or more repeating units of the polyimide, represented by the general formula (3), the groups R⁸ and R⁹ may be the same or different from each other.

The polyimides having the repeating unit of the general formula (3) can be obtained by, for example, reacting a tetracarbooxylic acid dianhalide with a diamine compound having phenolic hydroxyl group and, if necessary, a diamine compound free of phenolic hydroxyl group to form a polyamic acid and imidating this compound by heating.

This reaction is carried out preferably in an organic solvent. The tetracarboxylic acid dianhydrides usable herein are those described above as the starting materials for the polyamic acid esters having the repeating unit of the general formula (1). The diamines having phenolic hydroxyl group and diamines free of the phenolic hydroxyl group usable herein are those described above as the starting materials for the polyamic acid esters having the repeating unit of the general formula (1).

Processes for synthesizing the polyamic acids to be used as the intermediate for the polyimides are also well known. For example, these compounds are obtained by reacting the above-described tetracarboxylic acid dianhydride with the above-described diamine compound in a solution. The molar ratio of the tetracarboxylic acid dianhydride to the diamine compound is preferably in the range of 1/0.7 to 0.7/1, more preferably 1/0.8 to 0.8/1. The reaction temperature is preferably 20 to 100°C, and the reaction time is preferably 1 to 24 hours.

The solvents usable for the reaction are preferably aprotic polar solvents such as N-methyl-2-pyrrolidone, N,N-dimethylformamide, N,N-dimethylacetamide and dimethyl sulfoxide. They are usable either alone or in combination of two or more of them.

Processes for converting the polyamic acids to the polyimide by heating are well known. For example, such a compound is obtained by heating a polyamic acid, synthesized in an organic solvent, in the presence of xylene or the like, removing water, formed by the imidation reaction, by the azeotropy with xylene, feeding the product into a poor solvent such as water, filtering the resultant precipitate and drying it. The reaction temperature is preferably 150 to 200°C, and the reaction time is preferably 1 to 10 hours.

When the diamine compound free of phenolic hydroxyl group is also used in the production of the polyimide having the repeating unit of the general formula (3), the relative amounts of the diamine compound having phenolic hydroxyl group and the diamine compound free of phenolic hydroxyl group are such that preferably 20 to 100 molar % of the former and 80 to 0 molar % of the latter are used, more preferably, 40 to 100 molar % of the former and 60 to 0 molar % of the latter are used; the total of them being 100 molar %. When the amount of the former diamine compound used for imparting a solubility in an aqueous alkali solution to the polyimide is below 20 molar %, the sensitivity is reduced and the development time is prolonged.

The component (b) in the present invention is a polyamic acid having a siloxane bond, namely, -Si-O-Si- bond. The effects of the present invention such as the sensitivity, adhesion, pattern-forming property and heat resistance are obtained by the combination of the component (b) with the above-described component (a).

The polyamic acids (b) in the present invention are preferably those having a siloxane bond in the diamine residue, particularly polyamic acids having the repeating unit represented by the general formula (4) and excellent in adhesion and other properties are preferred.

The tetravalent organic groups represented by R¹⁰ in the above general formula (4) are residues derived from tetracarboxylic acid dianhydrides to be used as starting materials for the polyamides. These groups include tetravalent aromatic groups and aliphatic groups. Those having 4 to 40 carbon atoms are preferred. Tetravalent aromatic groups having 4 to 40 carbon atoms are more preferred. The tetravalent aromatic groups are preferably those having an aromatic ring (such as benzene ring or naphthalene ring), wherein the four positions of bonding them are on the aromatic ring. It is also preferred that the four bonding positions are divided into two groups each consisting of two bonding positions and that the two bonding positions are on carbon atoms, adjacent to each other, of an aromatic ring (namely, they are in the o-positions or peri-positions with each other). The two couples of the bonding positions may be on the same aromatic ring or on different aromatic rings bonded to each other through one of various bonds. q is preferably 1 to 70.

The part interposed between the two symbols R¹¹ is a siliconediamine compound residue obtained by removing the amino group from this compound. This part preferably has 6 to 40 carbon atoms as a whole. The divalent organic groups represented by R¹¹ are preferably those having 1 to 10 carbon atoms. Preferred examples of them are alkylene groups and phenylene groups having such a number of carbon atoms. The two symbols R¹¹ may be the same or different from each other. The monovalent organic groups represented by R¹² are preferably those having 1 to 6 carbon atoms, particularly alkyl groups and phenyl groups having such a number of carbon atoms. The four symbols R¹² may be the same or different from one another.

The components (b) may have a repeating unit other than that represented by the general formula (4). For example, the components (b) may have a repeating unit of the following general formula (9): 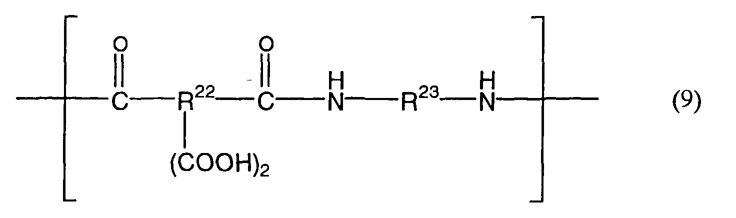 wherein R²² represents a tetravalent organic group and R²³ represents a divalent organic group.

The tetravalent organic groups represented by R²² in the general formula (9) are the same as those described above with reference to R¹ in the general formula (1). The divalent organic groups represented by R²³ are those described above with reference to R² in the general formula (1) and also those described above with reference to R¹⁴ in the general formula (6).

In the component (b), the ratio of the repeating unit of the general formula (4) to that of the general formula (9) is preferably as follows: o/(o+p) = 0.3 to 1, and more preferably o/(o+p) = 0.4 to 1 (wherein o represents the number of the repeating units of the former and p represents that of the latter). When o/(o+p) is below 0.3, the adhesion to the support inclines to be reduced.

The weight-average molecular weight of the component (b) is preferably 1,000 to 100,000, more preferably 5,000 to 100,000. The molecular weight is determined according to gel permeation chromatograhy followed by the calculation from a standard polystyrene calibration curve.

In two or more repeating units represented by the general formulae (4) and (9), the groups represented by the same symbol may be the same or different from each other.

In the present invention, the component (b) can be obtained by reacting a tetracarboxylic acid dianhydride, a diamine compound of the following general formula (10): 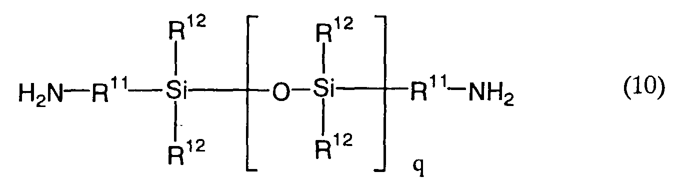 wherein R¹¹ and R¹² are the same as those in the general formula (4), and, if necessary, another diamine compound in a solution.

As the tetracarboxylic acid dianhydride, one or a combination of two or more of compounds described above as starting materials of the polyamic esters having the repeating unit of the above general formula (1) are usable.

Examples of the diamine compounds of the general formula (10) include compounds of the following formulae:

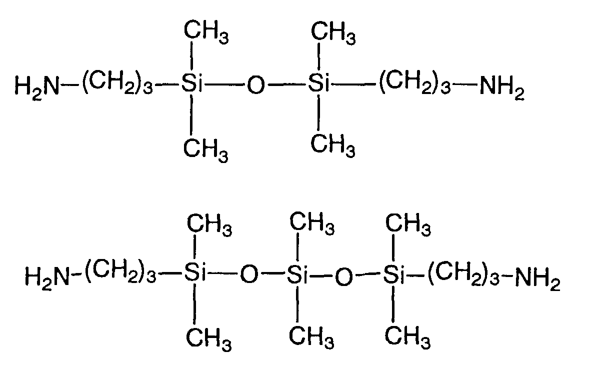

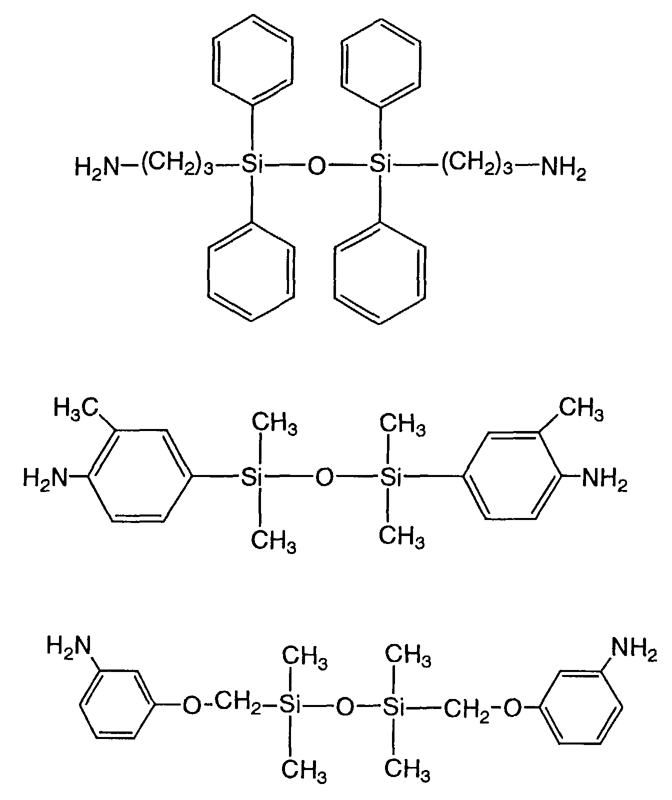

Commercially available diamine compounds are those of the above general formula (10) wherein each of both symbols R¹¹ represents a trimethylene group and each of all the symbols R¹² represents a methyl group, and q represents 1, about 10 on average, about 20 on average, about 30 on average or about 50 on average, which are available on the market under the trade names of LP-7100, X-22-161AS, X-22-161A, X-22-161B, X-22-161C and X-22-161E (products of Shin-etsu Chemicl Co., Ltd.), respectively.

Other diamine compounds are those illustrated above as starting materials for the polyamic acid esters having the repeating unit of the general formula (1). They are usable either alone or in combination of two or more of them.

The solvents usable herein are preferably aprotic polar solvents such as N-methyl-2-pyrrolidone, N,N-dimethylformamide, N,N-dimethylacetamide, dimethyl sulfoxide, hexamethylphosphoramide, tetramethylenesulfone and γ-butyrolactone. They are usable either alone or in combination of two or more of them.

The component (b) is produced preferably by dissolving the diamine compound in the aprotic solvent, adding the tetracarboxylic acid dianhydride to the solution and stirring the obtained mixture while the temperature is kept at below about 80 °C, preferably at around room temperature or below. The preferred molar ratio of the diamine compound of the general formula (10) to the other diamine compound is in the range of 7/3 to 1/0. The preferred molar ratio of the whole diamine compounds to the tetracarboxylic acid dianhydride is 0.8/1 to 1/0.8, more preferably 0.9/1 to 1/0.9. The preferred reaction time is from 3 to 24 hours. The reaction promptly takes place, the viscosity of reaction system gradually increases and then the polymer is produced.

In the heat resistant photosensitive polymer composition of the present invention, the amount of the component (b) is preferably 1 to 50 parts by weight, more preferably 2 to 20 parts by weight, for 100 parts by weight of the comonent (a) from the viewpoints of the adhesion of the formed membrane to the support and tolerance for film-remaining rate.

The photo acid generators (C) used in the present invention are photosensitizing agents which form an acid by the irradiation with light to increase the solubility of the irradiated part in an alkali. Although they are not particularly limited, o-quinone diazide compounds which are converted into 3-indenecarboxylic acid compounds by the irrariation with light have a remarkable effect and are preferred. The o-quinone diazide compounds are obtained by, for example, the condensation reaction of a quinone diazide sulfonylchloride with a hydroxy compound, amino compound or the like in the presence of a hydrochloric acid-removing catalyst.

The o-quinone diazide sulfonyl chlorides usable herein include benzoquinone-1,2-diazido-4-sulfonyl chloride, naphthoquinone-1,2-diazido-5-sulfonyl chloride and naphthoquinone-1,2-diazido-4-sulfonyl chloride. The hydroxy compounds usable herein include hydroquinone, resorcinol, pyrogallol, bisphenol A, bis(4-hydroxyphenyl)methane,2,2-bis(4-hydroxyphenyl) hexafluoropropane, 2,3,4-trihydroxybenzophenone, 2,3,4,4'-tetrahydroxybenzophenone, 2,2',4,4'-tetrahydroxybenzophenone, 2,3,4,2',3'-penta- hydroxybenzophenone, 2,3,4,3',4',5'-hexahydroxybenzophenone, bis(2,3,4-trihydroxyphenyl)methane, bis(2,3,4-trihydroxyphenyl)propane, 4b,5,9b, 10-tetrahydro-1,3,6,8-tetrahydroxy-5,10-dimethylindeno[2,1a]indene, tris(4-hydroxyphenyl)methane and tris(4-hydroxyphenyl)ethane.

The amino compounds usable herein include p-phenylenediamine, m-phenylenediamine, 4,4'-diaminodiphenyl ether, p-aminophenol, 4,4'-diaminodiphenylmethane, 4,4'-diaminodihenylsulfone, 4,4'-diaminodiphenyl sulfide, o-aminophenol, m-aminophenol, 3,3'-diamino-4,4'-dihydroxybiphenyl,4,4'-diamino-3,3'-dihydroxybiphenyl, bis(3-amino-4-hydroxyphenyl)propane, bis(4-amino-3-hydroxyphenyl)propane,bis(3-amino-4- hydroxyphenyl)sulfone, bis(4-amino-3-hydroxyphenyl)sulfone, bis(3-amino-4-hydroxyphenyl) hexafluoropropane and bis(4-amino-3-hydroxyphenyl) hexafluoropropane.

As for the relative amounts of the o-quinonediazidosulfonyl chloride and the hydroxyl compound and/or amino compound are preferably such that the total of hydroxyl group and amino group will be 0.5 to l equivalent per mol of the o-quinonediazidosulfonyl chloride. The preferred ratio of the amount of the dehydrochlogenation agent and that of o-quinonediazidosulfonyl chloride is in the range of 0.95/1 to 1/0.95.

The preferred reaction temperature is 0 to 40 °C and the preferred reaction time is 1 to 10 hours.

The reaction solvents usable herein include dioxane, acetone, methyl ethyl ketone, tetrahydrofuran, diethyl ether and N-methylpyrrolidone.

The hydrochloric acid-removing catalysts include sodium carbonate, sodium hydroxide, sodium hydrogencarbonate, potassium carbonate, potassium hydroxide, trimethylamine, triethylamine and pyridine.

In the heat resistant photosensitive polymer composition of the present invention, the amount of the component (c) is preferably 5 to 100 parts by weight, more preferably 10 to 40 parts by weight, for 100 parts by weight of the component (a) from the viewpoints of the difference in the solution velocity between the exposed area and the unexposed area and tolerance for the sensitivity.

The heat resistant photosensitive polymer composition of the present invention can be obtained by dissolving these components (a), (b) and (c) in a solvent.

The solvents are preferably aprotic polar solvents such as N-methyl-2-pyrrolidone, N,N-dimethylformamide, N,N-dimethylacetamide, dimethyl sulfoxide, hexamethylphoshoramide, tetramethylenesulfone and γ-butyrolactone. They are usable either alone or in combination of two or more of them, The amount of the solvent used is not particularly limited, and it is usually l0 to 90 % by weight based on the composition. The heat resistant photosensitive polymer composition of the present invention can further contain organosilane compounds and aluminum chelate compounds as adhesion assistant.

The organosilane compounds include, for example, γ-aminopropyl trimethoxysilane, γ-aminopropyltriethoxysilane, vinyltriethoxysilane, γ-glycidoxypropyltriethoxysilane and γ-methacryloxypropyltrimethoxysilane.

The aluminum chelating compounds include, for example, tris(acetylacetonato)aluminum and acetylacetatoaluminum diisopropylate.

When the adhesion assistant is used, the amount thereof is preferably 0.l to 20 parts by weight and more preferably 1 to 10 parts by weight for l00 parts by weight of the component (a).

The heat resistant photosensitive polymer composition of the present invention can be used for producing a polyimide relief pattern by a process comprising a step of applying it on a support and drying it followed by an exposing step, developing step and heating step.

In the step of applying it to a support and drying it, the heat resistant photosensitive polymer composition is applied to the support such as a glass support, semiconductor, metal oxide insulator (e. g. TiO₂ or SiO₂) or silicon nitride by a rotating method with a spinner or the like and then it is dried with a hot plate or an oven.

In the subsequent exposing step, the photosensitive polymer composition film formed on the support is irradiated with an active radiation such as ultraviolet rays, visible rays, ionizing radiation, or monochromatic light, e. g. g-ray or i-ray.

In the developing step, the exposed areas are removed with a developer to obtain a relief pattern. Preferred developers include aqueous solutions of alkalis such as sodium hydroxide, potassium hydroxide, sodium silicate, ammonia, ethylamine, diethylamine, triethylamine, triethanolamine and tetramethylammonium hydroxide. The base concentration in the aqueous solutions is preferably 0.1 to 10 % by weight. An alcohol or a surfactant can be added to the developer in an amount in the range of of preferably 0.01 to 10 parts by weight, more preferably 0.1 to 5 parts by weight, for 100 parts by weight of the developer.

In the heat treatment step, the relief pattern thus obtained is heat-treated at l50 to 450°C to obtain a heat-resistant relief pattern of the polyimide having imido rings and other cyclic groups.

The semiconductor equipment of the present invention is characterized by having a polyimide film obtained from the het-resisting photosensitive polymer composition, preferably a film of the polyimide obtained by the relief pattern preparation method as described above, as a buffer coating, passivation film, buffer coating film, α-ray shielding film, junction coating film or interlayer dielectric film. Other components constituting the semiconductor equipment are well known in the art.

The following Exmples will further illustrate the present invention.

### Example 1

25.77 g (0.08 mol) of 3,3',4,4'-benzophenonetetracarboxylic acid dianhydride and 59.30 g (0.8 mol) of n-butyl alcohol were fed into a 0.5 litter lask provided with a stirrer, a thermometer and a Dimroth condenser, and they were stirred at 95 °C for 5 hours to conduct the reaction. Superfluous n-butyl alcohol was distilled off under reduced pressure to obtain di-n-butyl 3,3',4,4'-benzophenonetetracarboxylate.

Then 95.17 g (0.8 mol) of thionyl chloride and 70.00 g of toluene were fed into the flask to conduct the reaction at 40 °C for 3 hours. Superfluous thionyl chloride was removed by the azeotropy with toluene under reduced pressure. 186 g of N-methylpyrrolidone was added to the reaction mixture to obtain a solution ( α ) of di-n-butyl 3,3',4,4'-benzophenonetetracarboxylate dichloride.

95 g of N-methylpyrrolidone, 7.30 g (0.048 mol) of 3,5-diaminobenzoic acid and 6.41 g (0.032 mol) of 4,4'-diaminodiphenyl ether were fed into a 0.5 litter flask provided with a stirrer, a thermometer and a Dimroth condenser, and they were stirred to obtain a solution. 12.66 g of pyridine was added to the solution. The solution (α) of di-n-butyl 3,3',4,4'-benzophenonetetracarboxylate dichloride was dropped in the obtained mixture during one hour while the temperature was kept at 0 to 5 °C. Then the stirring was continued for one hour The solution was poured into 4 litters of water, and the precipitates thus formed were recovered, washed and dried under reduced pressure to obtain n-butyl ester of the polyamic acid. This product had a weight-average molecular weight of 24,000 as determined by gel permeation chromatography followed by the calculation from a standard polystyrene calibration curve [device: a product of Hitachi, Ltd., column: GL-S 300 MPT-5 produced by Hitachi Chemical Co., Ltd. (two columns connected in series), eluent: THF/DMF=1/1, flow rate: l ml/min, detection wave length: 310 nm; the same shall apply hereinafter].

142 g of N-methyl-2-pyrrolidone was fed into a 0.5 litter flask provided with a stirrer, a thermometer, a nitrogen-introducing tube and a Dimroth condense, 24.85 g (0.1 mol) of a silicone diamine compound (the above-described LP 7100; a product of Shin-Etsu Chemical Co., Ltd.) was added thereto, and they were stirred to obtain a solution. 35.83 g (0.1 mol) of 3,3',4,4'-diphenylsulfonetetracarboxylic acid dianhydride was added to the solution and the resultant mixture was stirred at 25 °C for 8 hours to conduct the reactiion. The solution was poured into 1.5 litters of water, and the precipitates thus formed were recovered, washed and dried under reduced pressure to obtain polyamic acid. This product had a weight-average molecular weight of 26,000.

30.00 g of n-butyl ester of the polyamic acid, 1.50 g of polyamic acid and 7.50 g of an o-quinone diazide compound obtained by reacting 4,4'-diaminodiphenyl ether with naphthoquinone-1,2-diazido-5-sulfonyl chloride in a molar ratio of 1/2 were dissolved in 65.00 g of N-methylpyrrolidone under stirring. The obtained solution was filtered through a Teflon filter having a pore diameter of 3 µm under pressure to obtain a photosensitive polymer composition.

The photosensitive polymer composition thus obtained was applied to a silicon wafer with a spinner by the rotation method and then dried by heating on a hot plate at 105 °C for 3 minutes to obtain a 6 µm coating film. The coating film was exposed to a fight of 100 to 500 mJ/cm² through a mask with PLA (a product of Canon Inc.) as an exposing machine. Then the paddle development was conducted with 2.38 wt. % aqueous solution of tetramethylammonium hydroxide as the developer for 50 seconds. After washing with pure water, a relief pattern was obtained. By the observation of the pattern, the proper exposure was determined to be 300 mJ/cm2. The film-remaining rate in the unexposed area was 91 %. The obtained relief pattern was heat-treated at 350°C in nitrogen atmosphere for one hour to obtain a polyimide film pattern. The adhesion of the polyimide film to the support was determined by a cross-cut tape method (JIS K 5400) to obtain the result of 100/100 (The criteria were as follows: 0/100 indicates that the film was completely peeled off, and 100/100 indicates that the film was not peeled off at all).

### Example 2

28.66 g (0.08 mol) of 3,3',4,4'-biphenylsulfonetetracarboxylic acid dianhydride and 59.30 g (0.8 mol) of n-butyl alcohol were fed into a 0.5 littere flask provided with a stirrer, a thermometer and a Dimroth condenser, and they were stirred at 95°C for 5 hours to conduct the reaction. Superfluous n-butyl alcohol was distilled off under reduced pressure to obtain di-n-butyl 3,3',4,4'-biphenylsulfonetetracarboxylate.

Then 95.17 g (0.8 mol) of thionyl chloride and 70.00 g of toluene were fed into the flask to conduct the reaction at 40 °C for 3 hours. Superfluous thionyl chloride was removed by the azeotropy with toluene under reduced pressure. 193 g of N-methylpyrrolidone was added to the reaction mixture to obtain a solution ( β ) of di-n-butyl 3,3',4,4'-biphenylsulfonetetracarboxylate dichloride.

76 g of N-methylpyrrolidone, 8.52 g (0.056 mol) of 3,5-diaminobenzoic acid and 4.81 g (0.024 mol) of 4,4'-diaminodiphenyl ether were fed into a 0.5 litter flask provided with a stirrer, a thermometer and a Dimroth condenser, and they were stirred to obtain a solution. 12.66 g of pyridine was added to the solution. The solution (β) of di-n-butyl 3,3',4,4'-biphenylsulfonetetracarboxylate dichloride was dropped in the obtained mixture during one hour while the temperature was kept at 0 to 5°C. Then the stirring was continued for one hour. The solution was poured into 4 litter of water, and the precipitates thus formed were recovered, washed and dried under reduced pressure to obtain n-butyl ester of the polyamic acid. This product had a weight-average molecular weight of 19,000.

30.00 g of n-butyl ester of the polyamic acid, 1.50 g of the polyamic acid produced in Example l and 9.00 g of a compound obtained by reacting 4,4'-diaminodiphenylsulfone with naphthoquinone-1,2-diazido-5-sulfonyl chloride in a molar ratio of 1/2 were dissolved in 65.00 g of N-methylpyrrolidone under stirring. The obtained solution was filtered through a Teflon filter having a pore diameter of 3 µm under pressure to obtain a photosensitive polymer composition.

The photosensitive polymer composition thus obtained was applied to a silicon wafer with a spinner by the rotation method and then dried by heating on a hot plate at 110 °C for 3 minutes to obtain a 6 µm coating film. The coating film was exposed to a light of 100 to 500 mJ/cm² through a mask with PLA (a product of Canon Inc.) as an exposing machine. Then the paddle development was conducted with 2.38 wt. % aqueous solution of tetramethylammonium hydroxide as the developer for 40 seconds. After washing with pure water, a relief pattern was obtained. By the observation of the pattern, the proper exposure was determined to be 250 mJ/cm². The film-remaining rate in the unexposed area was 92 %. The obtained relief pattern was heat-treated at 350°C in nitrogen atmosphere for one hour to obtain a polyimide film pattern. The adhesion of the polyimide film to the support was determined by a cross-cut tape method (JIS K 5400) to obtain the result of 100/100.

### Example 3

17.45 g (0.08 mol) of pyromellitic acid dianhydride and 59.30 g (0.8 mol) of n-butyl alcohol were fed into a 0.5 litter flask provided with a stirrer, a thermometer and a Dimroth condenser, and they were stirred at 95°C for 5 hours to conduct the reaction. Superfluous n-butyl alcohol was distilled off under reduced pressure to obtain di-n-butyl pyromellitate.

Then 95.17 g (0.8 mol) of thionyl chloride and 70.00 g of toluene were fed into the flask to conduct the reaction at 40 °C for 3 hours. Superfluous thionyl chloride was removed by the azeotropy with toluene under reduced pressure. 166 g of N-methylpyrrolidone was added to the reaction mixture to obtain a solution ( γ ) of di-n-butyl pyromellitate dichloride.

76 g of N-methylpyrrolidone was fed into a 0.5 litter flask provided with a stirrer, a thermometer and a Dimroth condenser. 14.65 g (0.04 mol) of bis(3-amino-4-hydroxyphenyl)hexafluoropropane and 9.93 g (0.04 mol) of ,4'-diaminodiphenylsulfone were added thereto and the resultant mixture was stirred to obtain a solution. 12.66 g of pyridine was added to he solution. The solution (γ) of di-n-butyl pyromellitate dichloride was dropped in the obtained mixture under stirring during one hour while the temperature was kept at 0 to 5°C. Then the stirring was continued for one hour. The solution was poured into 4 litters of water, and the precipitates thus formed were recovered, washed and dried under reduced pressure to obtain n-butyl ester of the polyamic acid. This product had a weight-average molecular weight of 21,000.

30.00 g of n-butyl ester of the polyamic acid, 3.00 g of the polyamic acid produced in Example 1 and 6.00 g of a compound obtained by reacting tris(4-hydroxyphenyl)methane with naphthoquinone-1,2-diazido-5-sulfonyl chloride in a molar ratio of 1/2.5 were dissolved in 65.00 g of N-methylpyrrolidone under stirring. The obtained solution was filtered through a Teflon filter having a pore diameter of 3 µm under pressure to obtain a photosensitive polymer composition.

The photosensitive polymer composition thus obtained was applied to a silicon wafer with a spinner by the rotation method and then dried by heating on a hot plate at 105 °C for 3 minutes to obtain a 6 µm coating film. The coating film was exposed to a light of 100 to 500 mJ/cm² through a mask with PLA (a product of Canon Inc.) as an exposing machine. Then the paddle development was conducted with 2.38 wt. % aqueous solution of tetramethylammonium hydroxide as the developer for 50 seconds. After washing with pure water, a relief pattern was obtained. By the observation of the pattern, the proper exposure was determined to be 250 mJ/cm². The film-remaining rate in the unexposed area was 93 %. The obtained relief pattern was heat-treated at 350°C in nitrogen atmosphere for one hour to obtain a polyimide film pattern. The adhesion of the polyimide film to the support was determined by a cross-cut tape method (JIS K 5400) to obtain the result of 100/100.

### Comparative Example 1

30.00 g of n-butyl ester of the polyamic acid obtained in Example l and 7.50 g of a compound obtained by reacting 4,4'-diaminodiphenyl ether with naphthoquinone-1,2-diazido-5-sulfonyl chloride in a molar ratio of 1/2 were dissolved in 65.00 g of N-methylpyrrolidone under stirring. The obtained solution was filtered through a Teflon filter having a pore diameter of 3 µm under pressure to obtain a photosensitive polymer composition.

The photosensitive polymer composition thus obtained was applied to a silicon wafer with a spinner by the rotation method and then dried by heating on a hot plate at 80°C for 3 minutes to obtain a 6 µm coating film. The coating film was exposed to a light of 100 to 500 mJ/cm² through a mask with PLA (a product of Canon Inc.) as an exposing machine. Then the paddle development was conducted with 2.38 wt. % aqueous solution of tetramethylammonium hydroxide as the developer for 70 seconds. After washing with pure water, a relief pattern was obtained. By the observation of the pattern, the proper exposure was determined to be 250 mJ/cm². The film-remaining rate in the unexposed area was 84 %. The obtained relief pattern was heat-treated at 350°C in nitrogen atmosphere for one hour to obtain a polyimide film pattern. The adhesion of the polyimide film to the support was determined by a cross-cut tape method (JIS K 5400) to obtain the result of 32/100.

### Example 4

25.77 g (0.08 mol) of 3,3',4,4'-benzophenonetetracarboxyic acid dianhydride and 43.9 g (0.6 mol) of n-butylamine were fed into a 0.5 litter flask provided with a stirrer, a thermometer and a Dimroth condenser, and they were refluxed for 2 hours to conduct the reaction. Superfluous n-butylamine was distilled off under reduced pressure to obtain 3,3',4,4'-benzophenonetetracarboxylic acid bis(N-n-butylamide).

Then 23.8 g (0.2 mol) of thionyl chloride, 70.00 g of toluene and 0.5 ml of N,N-dimethylformamide were fed into the flask to conduct the reaction at 60 °C for one hour. Superfluous thionyl chloride was removed by the azeotropy with toluene under reduced pressure. 186 g of N-methylpyrrolidone was added to the reaction mixture to obtain a solution ( α ) of 3,3',4,4'-benzophenonetetracarboxylic acid bis(N-n-butylamide) dichloride.

95 g of N-methylpyrrolidone was fed into a 0.5 litter flask provided with a stirrer, a thermometer and a Dimroth condenser. 7.30 g (0.048 mol) of 3,5-diaminobenzoic acid and 6.41 g (0.032 mol) of 4,4'-diaminodiphenyl ether were added thereto and the resultant mixture was stirred to obtain a olution. 12.66 g of pyridine was added to the solution. The solution (α) of 3,3',4,4'-benzophenonetetracarboxylic acid bis(N-n-butylamide) dichloride was dropped in the obtained mixture under stirring during one hour while the temperature was kept at 0 to 5°C. Then the stirring was continued for one hour. The solution was poured into 4 litters of water, and the precipitates thus formed were recovered, washed and dried under reduced pressure to obtain polyamic N-n-butylamide. This product had a weight-average molecular weight of 27,500 as determined by gel permeation chromatography followed by the calculation from a standard polystyrene calibration curve [device: a product of Hitachi, Ltd., column: GL-S 300 MPT-5 produced by Hitachi Chemical Co., Ltd. (two columns connected in series), eluent: THF/DMF=1/1, flow rate: 1 ml/min, detection wave length: 310 nm].

142 g of N-methyl-2-pyrrolidone was fed into a 0.5 litter flask provided with a stirrer, a thermometer, a nitrogen-introducing tube and a Domroth condenser. 24.85 g (0.1 mol) of a silicone diamine compound (LP 7100; a product of Shin-Etsu Chemical Co., Ltd.) was added thereto, and they were stirred to obtain a solution. 35.83 g (0.1 mol) of 3,3',4,4'-diphenylsulfonetetracarboxylic acid dianhydride was added to the solution and the resultant mixture was stirred at 25 °C for 8 hours to conduct the reaction. The solution was poured into 1.5 litters of water, and the precipitates thus formed were recovered, washed and dried under reduced pressure to obtain a polyamic acid.

30.00 g of the polyamic acid N-n-butylamide, 1.50 g of the polyamic acid and 7.50 g of an o-quinone diazide compound obtained by reacting 4,4'-diaminodiphenyl ether with naphthoquinone-1,2-diazido-5-sulfonyl chloride in a molar ratio of 1/2 were dissolved in 65.00 g of N-methylpyrrolidone under stirring. The obtained solution was filtered through a Teflon filter having a pore diameter of 3 µm under pressure to obtain a photosensitive polymer composition.

The photosensitive polymer composition thus obtained was applied to a silicon wafer with a spinner by the rotation method and then dried by heating on a hot plate at 110 °C for 3 minutes to obtain a 6 µm coating film. The coating film was exposed to a light of 100 to 500 mJ/cm² through a mask with PLA (a product of Canon Inc.) as an exposing machine. Then the paddle development was conducted with 2.38 wt. % aqueous solution of tetramethylammonium hydroxide as the developer for 60 seconds. After washing with pure water, a relief pattern was obtained. By the observation of the pattern, the proper exposure was determined to be 300 mJ/cm². The film-remaining rate in the unexposed area was 90 %. The obtained relief pattern was heat-treated at 350°C in nitrogen atmosphere for one hour to obtain a polyimide film pattern. The adhesion of the polyimide film to the support was determined by a cross-cut tape method (JIS K 5400) to obtain the result of 100/100 (The criteria were as follows: 0/100 indicates that the film was completely peeled off, and 100/100 indicates that the film was not peeled off at all).

### Example 5

28.66 g (0.08 mol) of 3,3',4,4'-diphenylsulfonetetracarboxylic acid dianhydride and 43.9 g (0.6 mol) of n-butylamine were fed into a 0.5 fitter flask provided with a stirrer, a thermometer and a Domroth condenser, and they were refluxed for 2 hours to conduct the reaction. Superfluous n-butylamine was distilled off under reduced pressure to obtain 3,3',4,4'-diphenylsulfonetetracarboxylic acid bis(N-b-butylamide).

Then 23.8 g (0.2 mol) of thionyl chloride, 70.00 g of toluene and 0.5 ml of N,N-dimethylformamide were fed into the flask to conduct the reaction at 60 °C for 1 hour. Superfluous thionyl chloride was removed by the azeotropy with toluene under reduced pressure. 193 g of N-methylpyrrolidone was added to the reaction mixture to obtain a solution ( β ) of 3,3',4,4'-diphenylsulfonetetracarboxylic acid bis(N-n-butylamide) dichloride.

76 g of N-methylpyrrolidone was fed into a 0.5 litter flask provided with a stirrer, a thermometer and a Dimroth condense, 8.52 g (0.056 mol) of 3,5-diaminobenzoic acid and 4.81 g (0.024 mol) of 4,4'-diaminodiphenyl ether were added thereto, and they were stirred to obtain a solution. 12.66 g of pyridine was added to the solution. The solution (β) of 3,3',4,4'-biphenylsulfonetetracarboxylic acid bis(N-n-butylamide) dichloride was dropped in the obtained mixture during one hour while the temperature was kept at 0 to 5°C. Then the stirring was continued for one hour. The solution was poured into 4 litters of water, and the precipitates thus formed were recovered, washed and dried under reduced pressure to obtain the polyamic acid N-n-butylamide. This product had a weight-average molecular weight of 21,000.

30.00 g of the polyamic acid N-n-butylamide, 1.50 g of the polyamic acid produced in Example 4 and 9.00 g of a compound obtained by reacting 4,4'-diaminodiphenylsulfone with naphthoquinone-1,2-diazido-5-sulfonyl chloride in a molar ratio of 1/2 were dissolved in 65.00 g of N-methylpyrrolidone under stirring. The obtained solution was filtered through a Teflon filter having a pore diameter of 3 µm under pressure to obtain a photosensitive polymer composition.

The photosensitive polymer composition thus obtained was applied to a silicon wafer with a spinner by the rotation method and then dried by heating on a hot plate at 110 °C for 3 minutes to obtain a 6 µm coating film. The coating film was exposed to a light of 100 to 500 mJ/cm² through a mask with PLA (a product of Canon Inc.) as an exposing machine. Then the paddle development was conducted with 2.38 wt. % aqueous solution of tetramethylammonium hydroxide as the developer for 45 seconds. After washing with pure water, a relief pattern was obtained. By the observation of the pattern, the proper exposure was determined to be 400 mJ/cm². The film-remaining rate in the unexposed area was 88 %. The obtained relief pattern was heat-treated at 350°C in nitrogen atmosphere for 1 hour to obtain a polyimide film pattern. The adhesion of the polyimide film to the support was determined by a cross-cut tape method (JIS K 5400) to obtain the result of 100/100.

### Example 6

17.45 g (0.08 mol) of pyromellitic acid dianhydride and 43.9 g (0.6 mol) of n-butylamine were fed into a 0.5 litter flask provided with a stirrer, a thermometer and a Domroth condenser, and they were refluxed for 2 hours to conduct the reaction. Superfluous n-butylamine was distilled off under reduced pressure to obtain pyromellitic acid bis(N-n-butylamide).

Then 95.17 g (0.8 mol) of thionyl chloride, 70.00 g of toluene and 0.5 ml of N,N-dimethylformamide were fed into the flask to conduct the reaction at 60°C for one hour. Superfluous thionyl chloride was removed by the azeotropy with toluene under reduced pressure. 166 g of N-methylpyrrolidone was added to the reaction mixture to obtain a solution ( γ ) of pyromellitic acid bis(N-n-butylamide) dichloride.

76 g of N-methylpyrrolidone was fed into a 0.5 fitter flask provided with a stirrer, a thermometer and a Dimroth condenser. 14.65 g (0.04 mol) of bis(3-amino-4-hydroxyphenyl)hexafluoropropane and 9.93 g (0.04 mol) of 4,4'-diaminodiphenylsulfone were added thereto and the resultant mixture was stirred to obtain a solution. 12.66 g of pyridine was added to the solution. The solution ( γ ) of pyromellitic acid bis(N-n-butylamide) dichloride was dropped in the obtained mixture during one hour while the temperature was kept at 0 to 5°C. Then the stirring was continued for one hour. The solution was poured into 4 litters of water, and the precipitates thus formed were recovered, washed and dried under reduced pressure to obtain polyamic acid N-n-butylamide. This product had a weight-average molecular weight of 22,000.

30.00 g of the polyamic acid N-n-butylamide, 3.00 g of the polyamic acid obtained in Example 4 and 6.00 g of a compound obtained by reacting tris(4-hydroxyphenyl)methane with naphthoquinone-1,2-diazido-5-sulfonyl chloride in a molar ratio of 1/2.5 were dissolved in 65.00 g of N-methylpyrrolidone under stirring. The obtained solution was filtered through a Teflon filter having a pore diameter of 3 µm under pressure to obtain a photosensitive polymer composition.

The photosensitive polymer composition thus obtained was applied to a silicon wafer with a spinner by the rotation method and then dried by heating on a hot plate at 110 °C for 3 minutes to obtain a 6 µm coating film. The coating film was exposed to a light of 100 to 500 mJ/cm² through a mask with PLA (a product of Canon Inc.) as an exposing machine. Then the paddle development was conducted with 2.38 wt. % aqueous solution of tetramethylammonium hydroxide as the developer for 60 seconds. After washing with pure water, a relief pattern was obtained. By the observation of the pattern, the proper exposure was determined to be 350 mJ/cm². The film-remaining rate in the unexposed area was 91 %. The obtained relief pattern was heat-treated at 350°C in nitrogen atmosphere for 1 hour to obtain a polyimide film pattern. The adhesion of the polyimide film to the support was determined by a cross-cut tape method (JIS K 5400) to obtain the result of 100/100.

### Comparative Example 2

30.00 g of the polyamic acid N-n-butylamide obtained in Example 4 and 7.50 g of a compound obtained by reacting 4,4'-diaminodiphenyl ether with naphthoquinone-1,2-diazido-5-sulfonyl chloride in a molar ratio of 1/2 were dissolved in 65.00 g of N-methylpyrrolidone under stirring. The obtained solution was filtered through a Teflon filter having a pore diameter of 3 µm under pressure to obtain a photosensitive polymer composition.

The photosensitive polymer composition thus obtained was applied to a silicon wafer with a spinner by the rotation method and then dried by heating on a hot plate at 100 °C for 3 minutes to obtain a 6 µm coating film. The coating film was exposed to a fight of 100 to 500 mJ/cm² through a mask with PLA (a product of Canon Inc.) as an exposing machine. Then the paddle development was conducted with 2.38 wt. % aqueous solution of tetramethylammonium hydroxide as the developer for 70 seconds. After washing with pure water, a relief pattern was obtained. By the observation of the pattern, the proper exposure was determined to be 300 mJ/cm². The film-remaining rate in the unexposed area was 87 %. The obtained relief pattern was heat-treated at 350 °C in nitrogen atmosphere for one hour to obtain a polyimide film pattern. The adhesion of the polyimide film to the support was determined by a cross-cut tape method (JIS K 5400) to obtain the result of 18/100.

### Example 7

196 g of N-methyl-2-pyrrolidone and 48 g of xylene were fed into a 0.5 fitter flask provided with a stirrer, a thermometer and a Dimroth condenser. 21.98 g (0.06 mol) of bis(3-amino-4-hydroxyphenyl) hexafluoropropane and 9.94 g (0.03 mol) of 4,4'-diaminodiphenylsulfone were added thereto, and the obtained mixture was stirred to obtain a solution. 35.82 g (0.10 mol) of 3,3',4,4'-biphenylsulfonetetracarboxylic acid dianhydride was added to the solution. After continuing the stirring for 3 hours, the polyamic acid solution was obtained.

Then a water-content meter was attached to the flask. Water formed by the imidation reaction was removed by the azeotropy with xylene under heating at 160 °C for 2 hours. After cooling, the solution was thrown into 3 litters of water. The precipitates thus obtained were recovered, washed and dried under reduced pressure to obtain a polyimide. 142 g of N-methyl-2-pyrrolidone was fed into a 0.5 litter flask provided with a stirrer, a thermometer, a nitrogen-introducing tube and a Domroth condenser. 24.85 g (0.1 mol) of a siliconediamine compound (the above-described LP 7100; a product of Shin-Etsu Chemical Co., Ltd.) was added thereto and the resultant mixture was stirred to obtain a solution. 35.83 g (0.1 mol) of 3,3',4,4'-dihenylsulfonetetracarboxylic acid dianhydride was added to the solution. The obtained mixture was stirred at 25 °C for 8 hours to conduct the reaction. The reaction solution was thrown into 1.5 litter of water, and the precipitates thus formed were recovered, washed and dried under reduced pressure to obtain the polyamic acid.

15.00 g of the polyimide, 0.75 g of the polyamic acid and 2.25 g of an o-quinonediazide obtained by reacting tris(4-hydroxyphenyl)methane with naphthoquinone-1,2-diazido-5-sulfonyl chloride in a molar ratio of 1/3 were dissolved in 45.00 g of γ-butyrolactone under stirring. The obtained solution was filtered through a Teflon filter having a pore diameter of 3 µm under pressure to obtain a photosensitive polymer composition.

The photosensitive polymer composition thus obtained was applied to a silicon wafer with a spinner by the rotation method and then dried by heating on a hot plate at 110 °C for 3 minutes to obtain a 5 µm coating film. The coating film was exposed to a light of 100 to 500 mJ/cm² through a mask with PLA (a product of Canon Inc.) as an exposing machine. Then the paddle development was conducted with 2.38 wt % aqueous solution of tetramethylammonium hydroxide as the developer for 40 seconds. After washing with pure water, a relief pattern was obtained. By the observation of the pattern, the proper exposure was determined to be 250 mJ/cm². The obtained relief pattern was heat-treated at 350 °C in nitrogen atmosphere for 1 hour to obtain a polyimide film pattern. The adhesion of the polyimide film to the support was determined by a cross-cut tape method (JIS K 5400) to obtain the result of 100/100 (The criteria were as follows: 0/100 indicates that the film was completely peeled off, and 100/100 indicates that the film was not peeled off at all).

### Example 8

164 g of N-methyl-2-pyrrolidone and 40 g of xylene were fed into a 0.5 litter flask provided with a stirrer, a thermometer and a Dimroth condenser. 14.02 g (0.05 mol) of bis(3-amino-4-hydroxyphenyl)sullfone and 12.42 g (0.05 mol) of 4,4'-diaminodiphenylsulfone were added thereto, and the obtained mixture was stirred to obtain a solution. 27.92 g (0.09 mol) of 3,3',4,4'-biphenyl ether tetracarboxylic acid dianhydride was added to the solution. After continueing the stirring for 3 hours, the polyamic acid solution was obtained.

Then a water-content meter was attached to the flask. Water formed by the imidation reaction was removed by the azeotropy with xylene by heating at 160°C for 2 hours . After cooling, the solution was thrown into 1.5 litter of water. The precipitates thus obtained were recovered, washed and dried under reduced pressure to obtain a polyimide.

15.00 g of the polyimide, 0.75 g of the polyamic acid obtained in Example 7 and 2.25 g of a compound obtained by reacting tris(4-hydroxyphenyl)methane with naphthoquinone-1,2-diazido-5-sulfonyl chloride in a molar ratio of 1/3 were dissolved in 45.00 g of N-methylpyrrolidone under stirring. The obtained solution was filtered through a Teflon filter having a pore diameter of 3 µm under pressure to obtain a photosensitive polymer composition.

The photosensitive polymer composition thus obtained was applied to a silicon wafer with a spinner by the rotation method and then dried by heating on a hot plate at 110 °C for 3 minutes to obtain a 5 µm coating film. The coating film was exposed to a light of 100 to 500 mJ/cm² through a mask with PLA (a product of Canon Inc.) as an exposing machine. Then the paddle development was conducted with 2.38 wt. % aqueous solution of tetramethylammonium hydroxide as the developer for 30 seconds. After washing with pure water, a relief pattern was obtained. By the observation of the pattern, the proper exposure was determined to be 250 mJ/cm². The obtained relief pattern was heat-treated at 350 °C in nitrogen atmosphere for one hour to obtain a polyimide film pattern. The adhesion of the polyimide film to the support was determined by a cross-cut tape method (JIS K 5400) to obtain the result of 100/100.

### Comparative Example 3

15.00 g of the polyimide obtained in Example 7 and 2.25 g of a compound obtained by reacting tris(4-hydroxyphenyl)methane with naphthoquinone-1,2-diazido-5-sulfonyl chloride in a molar ratio of 1/3 were dissolved in 45.00 g of γ-butyrolactone under stirring. The obtained solution was filtered through a Teflon filter having a pore diameter of 3 µm under pressure to obtain a photosensitive polymer composition.

The photosensitive polymer composition thus obtained was applied to a silicon wafer with a spinner by the rotation method and then dried by heating on a hot plate at 80°C for 3 minutes to obtain a 6 µm coating film. The coating film was exposed to a fight of 100 to 500 mJ/cm² through a mask with PLA (a product of Canon Inc.) as an exposing machine. Then the paddle development was conducted with 2.38 wt. % aqueous solution of tetramethylammonium hydroxide as the developer for 40 seconds. After washing with pure water, a relief pattern was obtained. By the observation of the pattern, the proper exposure was determined to be 300 mJ/cm². The obtained relief pattern was heat-treated at 350 °C in nitrogen atmosphere for one hour to obtain a polyimide film pattern. The adhesion of the polyimide film to the support was determined by a cross-cut tape method (JIS K 5400) to obtain the result of 0/100.

As mentioned above the heat resistant photosensitive polymer compositions of the present invention have a high sensitivity and the development time of them can be reduced. The properties of the films formed from them are excellent, and the adhesion of the films to a support is particularly high.

The process of the present invention is capable of preparing a pattern having a high sensitivity and of reducing the development time. The patterns prepared by this process have excellent properties, particularly a high adhesion to the support. The patterns are usable for producing semiconductor devices, buffer coatings for multi-layer wiring boards, and interlayer dielectric films.

In the semiconductor device of the present invention, the adhesion of the buffer coating or interlayer dielectric film to the support is excellent, and the device is highly reliable.

## Claims

1. A heat resistant photosensitive polymer composition comprising:
(a) a polyimide precursor or a polyimide having a carboxyl group or a phenolic hydroxyl group,
(b) a polyamic acid having a siloxane bond, and
(c) a photo acid generator.

2. The heat resistant photosensitive polymer composition set forth in claim 1, wherein the polyimide precursor or polyimide (a) having a carboxyl group or a phenolic hydroxyl group is selected from among the following compounds each having a repeating unit: polyamic acid esters having a repeating unit of the general formula (1): 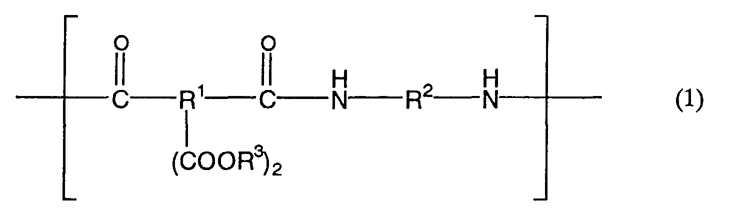 wherein R¹ represents a tetravalent organic group, R² represents a divalent organic group having a carboxyl group or a phenolic hydroxyl group, and R³ represents a monovalent organic group,
polyamic acid amides having a repeating unit of the general formula (2): 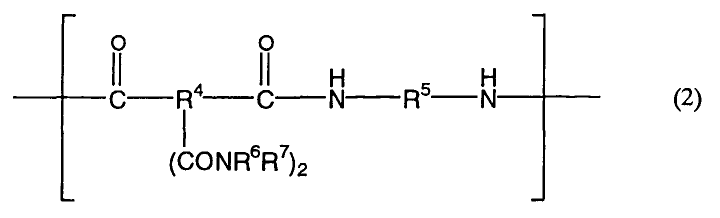 wherein R⁴ represents a tetravalent organic group, R⁵ represents a divalent organic group having a carboxyl group or a phenolic hydroxyl group, and R⁶ and R⁷ each represent a hydrogen atom or a monovalent organic group, and
polyimides having a repeating unit of the general formula (3): 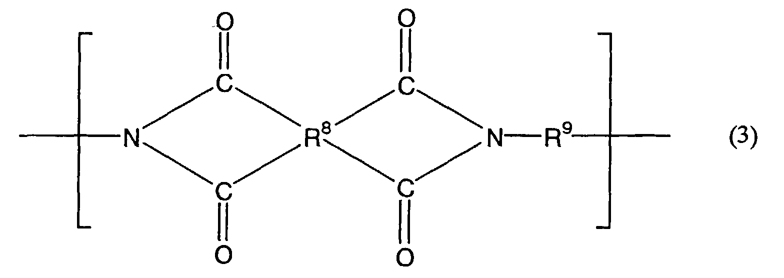 wherein R⁸ represents a tetravalent organic group and R⁹ represents a divalent organic group having a phenolic hydroxyl group.

3. The composition set forth in claim 2, wherein R¹ represents a tetravalent aromatic group or aliphatic group having 4 to 40 carboon atoms.

4. The composition set forth in claim 3, wherein R¹ represents a tetracarboxylic acid residue or a tetracarboxylic acid dianhydride derivative residue.

5. The composition set forth in claim 2, wherein R² represents an aromatic group or aliphatic group having 2 to 40 carbon atoms (excluding carbon atom of the carboxyl group) and capable of forming a polyimide structure by reacting with a tetracarboxylic acid.

6. The composition set forth in claim 5, wherein R² represents a residue having l to 8 carboxyl groups or phenolic hydroxyl groups.

7. The composition set forth in claim 2, wherein R³ represents an aliphatic group or aromatic group having 1 to 20 carbon atoms.

8. The composition set forth in claim 2, wherein R⁴ represents a tetravalent aromatic group or aliphatic group having 4 to 40 carbon atoms.

9. The composition set forth in claim 8, wherein R⁴ represents a tetracarboxylic acid residue or a tetracarboxylic acid dianhydride derivative residue.

10. The composition set forth in claim 2, wherein R⁵ represents an aromatic group or aliphatic group having 2 to 40 carbon atoms (excluding carbon atom of the carboxyl group) and capable of forming a polyimide structure by reacting with a tetracarboxylic acid.

11. The composition set forth in claim 10, wherein R⁵ represents a residue having 1 to 8 carboxyl groups or phenolic hydroxyl groups.

12. The composition set forth in claim 11, wherein R⁶ and R⁷ each represent an aliphatic group or aromatic group having 1 to 20 carbon atoms.

13. The composition set forth in claim 2, wherein R⁸ represents a tetravalent aromatic group or aliphatic group having 4 to 40 carbon atoms.

14. The composition set forth in claim 13, wherein R⁸ represents a tetracarboxylic acid residue or a tetracarboxylic acid dianhydride derivative residue.

15. The composition set forth in claim 2, wherein R⁹ represents an aromatic group or aliphatic group having 2 to 40 carbon atoms (excluding carbon atom of the carboxyl group) and capable of forming a polyimide structure by reacting with a tetracarboxylic acid.

16. The composition set forth in claim 15, wherein R⁹ represents a residue having 1 to 8 carboxyl groups or phenolic hydroxyl groups.

17. The heat resistant photosensitive polymer composition set forth in claim 1, wherein the polyamic acid (b) having a siloxane structure is a polyamic acid having a repeating unit of the general formula (4): 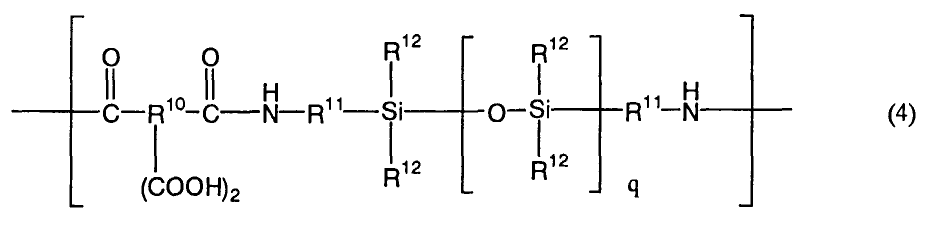 wherein R ¹⁰ represents a tetravalent organic group, R¹¹ represents a divalent organic group, R¹² represents a monovalent organic group, and q represents an integer of at least 1.

18. The composition set forth in claim 17, wherein R¹⁰ represents a tetravalent aromatic group or aliphatic group having 4 to 40 carbon atoms.

19. The composition set forth in claim 17, wherein R¹⁰ represents a tetracarboxylic acid dianhydride residue having 4 to 40 carbon atoms.

20. The heat resistant photosensitive polymer composition set forth in claim 1, wherein the photo acid generator (c) is an o-quinone diazide compound.

21. The composition set forth in claim 1, wherein the amount of the component (b) is 1 to 50 parts by weight for 100 parts by weight of the component (a).

22. The composition set forth in claim 1, wherein the amount of the component (c) is 5 to 100 parts by weight for 100 parts by weight of the component (a).

23. A process for forming a pattern, which comprises a step of applying the heat resistant photosensitive polymer composition set forth in any of claims 1 to 22 to a support and drying it, followed by an exposing step, a developing step and a heat treatment step.

24. A semiconductor device having a polyimide resin film comprising the heat resistant photosensitive polymer composition set forth in any of claims l to 22.
